# EUROPEAN PATENT APPLICATION

(11) **EP 4 379 771 A1**
(43) Date of publication of application: **05.06.2024**
(21) Application number: 22210502.5
(22) Date of filing: 30.11.2022

(54) **PACKAGE WITH COMPONENT CARRIER AND ELECTRONIC COMPONENT CONNECTED WITH DIRECT PHYSICAL CONTACT AT STRESS RELEASE LAYER**

(71) Applicant: AT & S Austria Technologie & Systemtechnik Aktiengesellschaft, 8700 Leoben (AT)
(72) Inventor: Stahr, Johannes, 8605 St. Lorenzen im Mürztal (AT); Schwarz, Timo, 8770 St. Michael i. O. (AT); Zluc, Andreas, 8700 Leoben (AT)
(74) Representative: Dilg, Haeusler, Schindelmann Patentanwaltsgesellschaft mbH

(57) **Abstract**

A package (100) which comprises a component carrier (102) having at least one exposed electrically conductive carrier contact (104) and having an exposed carrier dielectric (106), and an electronic component (108) having an integrated circuit (136), having at least one exposed component pad (110) and having an exposed component dielectric (112), wherein the component carrier (102) is connected with the electronic component (108) so that there is a connection between the at least one carrier contact (104) and the at least one component pad (110) and so that there is a direct physical contact between the carrier dielectric (106) and the component dielectric (112), and wherein at least one of the carrier dielectric (106) and the component dielectric (112) comprises a stress release structure (150, 152) at its surface facing the respectively other one of the carrier dielectric (106) and the component dielectric (112).

## Description

### Field of the Invention

The invention relates to a package, to a component carrier, and to a method of manufacturing a package.

### Technological Background

In the context of growing product functionalities of component carriers equipped with one or more components and increasing miniaturization of such components as well as a rising number of components to be connected to the component carriers such as printed circuit boards or component carriers, increasingly more powerful array-like components or packages having several components are being employed, which have a plurality of contacts or connections, with smaller and smaller spacing between these contacts. In particular, component carriers shall be mechanically robust and electrically reliable so as to be operable even under harsh conditions.

Conventional approaches of forming and handling component carriers are still challenging in particular what concerns surface mounting of electronic components thereon and/or therein.

### Summary of the Invention

There may be a need to form a compact and reliable component carrier-type package.

According to an exemplary embodiment of the invention, a package is provided which comprises a component carrier having at least one exposed electrically conductive carrier contact and having an exposed carrier dielectric (for example a structured carrier dielectric layer with said at least one carrier contact surrounded by said carrier dielectric layer), and an electronic component having an integrated circuit, having at least one exposed component pad and having an exposed component dielectric (for example a structured component dielectric layer with said at least one component pad surrounded by said component dielectric layer), wherein the component carrier is connected with the electronic component so that there is a connection between the at least one carrier contact and the at least one component pad and so that there is a direct physical contact between the carrier dielectric and the component dielectric, and wherein at least one of the carrier dielectric and the component dielectric comprises a stress release structure at its surface facing the respectively other one of the carrier dielectric and the component dielectric.

According to another exemplary embodiment of the invention, a component carrier is provided which comprises a stack comprising at least one electrically conductive layer structure having at least one exposed carrier contact and at least one electrically insulating layer structure having an exposed carrier dielectric, and wherein the carrier dielectric comprises a stress release structure at its exterior surface for direct connection with a component dielectric of an electronic component.

According to still another exemplary embodiment of the invention, a method of manufacturing a package is provided, wherein the method comprises providing a component carrier having at least one exposed carrier contact and having an exposed carrier dielectric, providing an electronic component having an integrated circuit, having at least one exposed component pad and having an exposed component dielectric, connecting the component carrier with the electronic component so that there is a connection between the at least one carrier contact and the at least one component pad and so that there is a direct physical contact between the carrier dielectric and the component dielectric, and providing at least one of the carrier dielectric and the component dielectric with a stress release structure at its surface facing the respectively other one of the carrier dielectric and the component dielectric.

In the context of the present application, the term "package" may particularly denote a device having at least one electronic component (such as a semiconductor chip) being surface mounted on and/or embedded in a component carrier (like an integrated circuit (IC) substrate or a printed circuit court (PCB)) being mechanically and electrically connected with each other. Such a package may be a constituent of more complex electronic devices.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In the context of the present application, the term "exposed carrier contact" may particularly denote a planar electrically conductive contact element of the component carrier being accessible at a main surface of the component carrier for electric connection purposes. The main horizontal extension (i.e. perpendicular to the thickness direction of the component carrier) of the exposed carrier contact may be parallel to the plane of the layers of the component carrier stack. For instance, a carrier contact may be a pad, a metal pillar, etc.

In the context of the present application, the term "exposed carrier dielectric" may particularly denote an electrically insulating surface area of the component carrier being accessible at a main surface of the component carrier for mechanical, but not for electric connection purposes. The exposed carrier dielectric may be constituted by a stress release structure. Preferably, the surface of the exposed carrier dielectric may be located on the same level regarding stack thickness direction as the exposed carrier contact. In other words, the exposed carrier dielectric and the exposed carrier contact may be flush.

In the context of the present application, the term "electronic component having an integrated circuit" (also denoted as IC-type electronic component) may particularly denote a device fulfilling an electronic task and having at least one integrated circuit element (such as a transistor or a diode) monolithically integrated in a semiconductor body (for instance a silicon body or a body being partially of a semiconductor and partially of organic material). Such an electronic component may be an active component such as a semiconductor chip comprising a semiconductor material, in particular as a primary or basic material. Said semiconductor chip may for example be an active semiconductor chip or a passive semiconductor chip (such as a bridge chip). The semiconductor material may for instance be a type IV semiconductor such as silicon or germanium, or may be a type III-V semiconductor material such as gallium arsenide, gallium nitride, indium phosphide. Moreover, semiconductor materials suitable for photonic packages are also possible. In particular, the semiconductor component may be a semiconductor chip such as a bare die or a molded die. A bare die may be a non-encapsulated (in particular non-molded) piece of semiconductor material (such as silicon) having at least one monolithically integrated circuit element (such as a diode or a transistor). For example, such an electronic component may be an HBM (high-bandwidth memory) or a silicon interposer. It is also possible to surface mount a plurality of integrated circuit components on an integrated circuit component mounting side of the component carrier.

In the context of the present application, the term "exposed component pad" may particularly denote a planar electrically conductive contact element of the electronic component being accessible at a main surface of the electronic component for electric connection purposes. The main horizontal extension (i.e. perpendicular to the thickness direction of the component) of the exposed component pad may be parallel to the plane of the layers of the component carrier stack.

In the context of the present application, the term "exposed component dielectric" may particularly denote an electrically insulating surface area of the electronic component being accessible at a main surface of the electronic component for mechanical, but not for electric connection purposes. Preferably, the surface of the exposed component dielectric may be located on the same level regarding stack thickness direction as the exposed component pad. In other words, the exposed component dielectric and the exposed component pad may be flush.

In the context of the present application, the term "direct physical contact" may particularly denote a face-to-face contact between two connected entities contacting each other without an additional intermediate material in between. Such a direct physical contact may also establish a direct physical connection between said connected entities. Correspondingly connected entities may not be separated from each other without applying high force and/or thermal energy or without damage. In particular, direct physical contact between the exposed component pad and the exposed carrier contact may create an electric connection between the component carrier and the electronic com ponent.

In the context of the present application, the term "stack" may particularly denote a flat or planar sheet-like body. For instance, the stack may be a layer stack, in particular a laminated layer stack or a laminate. Such a laminate may be formed by connecting a plurality of layer structures by the application of mechanical pressure and/or heat. Preferably, the (in particular laminated) layers may be parallel shifted (in stack thickness direction) in space.

In the context of the present application, the term "layer structure" may particularly denote a continuous layer, a patterned layer or a plurality of nonconsecutive islands within a common plane.

In the context of the present application, the term "stress release structure" may particularly denote a structure forming part of an exposed surface of the carrier dielectric and/or of the component dielectric and being configured for releasing stress from an interface between the component carrier and the electronic component which may be directly electrically coupled with each other with direct physical contact. Such a stress may be created when directly connecting component carrier and electronic component with each other, in particular by oxide bonding and/or hybrid bonding. In particular by adjusting material properties, such as the value of the coefficient of thermal expansion (CTE) and/or the value of the Young modulus, of the respective stress release structure interface stress may be reduced or even eliminated. Such a stress may result from different material properties of the electronic component and the component carrier, in particular what concerns the coefficient of thermal expansion. An abrupt change of such material properties at the interface between electronic component and component carrier may cause mechanical and/or thermal stress which may lead to undesired phenomena such as warpage, delamination, cracks, separation between electronic component and component carrier and/or insufficient electric connection in between. A stress reducing dielectric interface at an exposed dielectric surface of the electronic component and/or of the component carrier may at least reduce exerted stress. For example, this may be accomplished by a very smooth connection surface of a stress release structure, reducing or eliminating CTE mismatch between electronic component and component carrier, and/or a stress release structure providing balanced properties in terms of stiffness versus softness. Preferably, the exterior surface of the stress release structure of the component carrier may be formed by silicon oxide. For example, a stress release structure may be a stress release layer. In addition to the one or two stress release structures of component carrier and electronic component at the connection surface in between, the package may optionally comprise at least one further stress release structure embedded in an interior of the stack of the component carrier.

In the context of the present application, the term "main surface" of a body may particularly denote one of two largest opposing surfaces of the body. The main surfaces may be connected by circumferential side walls. The thickness of a body, such as a stack, may be defined by the distance between the two opposing main surfaces.

According to an exemplary embodiment of the invention, a package architecture is provided in which an at least partially direct physical connection between a component carrier and a surface mounted IC-type electronic component is created for establishing an intimate integrally formed connection in between. For this purpose, not only a connection between exposed pads of electronic component and component carrier may be established, but also a direct physical connection between exposed dielectric surface regions on facing main surfaces of component carrier and electronic component may be established by a direct bonding process. By such a direct bonding approach, chip assembly on a component carrier may be significantly simplified. This contributes to the compactness of the package in vertical direction, since neither solder material nor an interposer needs to be present between component carrier and IC-type electronic component. Hence, in addition to a simple assembly process, even shorter z-interconnections (i.e. electrically conductive connections in the vertical direction) may be created. Moreover, the mentioned direct connection technology may promote formation of fine-line structures between component carrier and electronic component. Advantageously, one or two opposing stress release structure(s) which may be located directly at a physical interface between component carrier and electronic component may balance out stress between the possibly quite heterogeneous bonding partners in form of (for example laminate-type) component carrier and (for instance semiconductor-based) electronic component. This may improve the mechanical, thermal and electric reliability of the package.

### Detailed Description of Exemplary Embodiments

In the following, further exemplary embodiments of the package, the component carrier and the method will be explained.

In an embodiment, the component carrier can comprise a layer stack with a redistribution structure. In the context of the present application, the term "redistribution structure" may particularly denote patterned electrically conductive layers and/or vertical interconnects which have a portion (in particular a bottom-sided portion) with a higher pitch as compared to another portion (in particular a top-sided portion (or at the opposed side)) with a smaller pitch. Pitch may denote a characteristic distance between adjacent electrically conductive structures, such as wiring elements or terminals. By providing spatially separate regions with different pitch, a redistribution layer may be an electric interface between larger dimensioned electric connection structures (in particular relating to component carrier technology, more particularly printed circuit board technology or integrated circuit substrate technology) and smaller dimensioned electric connection structures (in particular relating to semiconductor chip technology, wherein the surface mounted component may be a semiconductor chip).

In an embodiment, the method comprises connecting the component carrier with the electronic component by permanent bonding. Preferably, said permanent bonding may be accomplished by hybrid bonding, diffusion bonding and/or thermocompression bonding. However, other permanent bonding processes may be executed as well.

Hybrid bonding may combine a dielectric bond (between the exposed carrier dielectric and the exposed component dielectric) with a metal bond (between the exposed carrier contact and the exposed component pad) to form an interconnection. Hybrid bonding may be executed at room temperature, followed by an annealing process at elevated temperature (for instance in a temperature range from 150°C to 300°C). In particular, hybrid bonding may be initiated at room temperature, between the dielectrics of the electronic component and the component carrier, further executed by an annealing process at elevated temperature.

Diffusion bonding may denote a solid-state welding technique for joining similar and dissimilar metals. Diffusion bonding may operate on the principle of solid-state diffusion, wherein the atoms of two solid, metallic surfaces intersperse themselves over time. This may be accomplished at an elevated temperature, for example in a temperature range from 50% to 75% of the absolute melting temperature of the materials.

Thermocompression bonding may denote a bonding technique in which two metals are brought into atomic contact applying force and heat simultaneously. The diffusion process may involve atomic contact between the surfaces due to atomic motion. The atoms migrate from one crystal lattice to the other one leading to an atomic interaction sticking the interfaces together. Preferably, the metals do not comprise a portion of metal salts (e.g. metal oxide).

In an embodiment, the contact between the carrier dielectric and the component dielectric may be forced by Van der Waals bonding.

In an embodiment, at least one of the carrier dielectric and the component dielectric consists of a stress release structure at its surface facing the respectively other one of the carrier dielectric and the component dielectric. In other words, the exposed dielectric surface of the respective one of the component carrier or the electronic component may be formed exclusively by the stress release structure.

In an embodiment, the component carrier comprises an organic dielectric. In particular, the component carrier may be a laminate-type component carrier having a plurality of electrically insulating layer structures, wherein at least one of which may comprise an organic material, such as an organic compound. An organic compound may be a chemical compound that contains carbon-hydrogen bonds. For example, the organic material may comprise an organic resin material, an epoxy material, etc. The stress release structure may, however, be made of an inorganic material.

In an embodiment, the component carrier is connected with the electronic component so that there is a direct physical contact between the at least one carrier contact and the at least one component pad. Hence, each carrier contact may be in contact with each respective component pad without any intermediate material in between.

In another embodiment, the connection between the at least one carrier contact and the at least one component pad is provided by a solder structure in between. Such a solder structure may be embodied as a solderable surface layer on the respective carrier contact and/or component pad. Triggered by elevated temperature and/or pressure, diffusion soldering between carrier contact and component pad, realized by the solder structure, may then be executed. For example, said solder structure can be a metal or a soldering diffusion material. In particular, the solder structure may comprise tin.

In an embodiment, each of the carrier dielectric and the component dielectric comprises (in particular consists of) a stress release structure at its surface facing the respectively other one of the carrier dielectric and the component dielectric. Thus, both opposing and exposed main surfaces of component carrier and electronic component to be connected may be equipped with a respective stress release structure. As a result of the connection between component carrier and electronic component, a stress release double structure may thus be formed. Double-sided stress release may lead to excellent results in terms of interconnecting component carrier and electronic component and introduces an additional amount of degrees of freedom for adjusting the stress release properties.

In an embodiment, the at least one stress release structure has a surface roughness Ra of less than 1 µm, in particular less than 10 nm, more particularly less than 1 nm. For example, a silicon oxide or glass layer may be manufactured with the described smoothness. Hence, the exposed surface of the stress release structure may be extremely smooth. This may efficiently promote an excellent connection between component carrier and electronic component without the risk of separation. The external surface facing the respectively other one of the carrier dielectric and the component dielectric may thus be very smooth.

In an embodiment, an exterior surface of the at least one stress release structure is formed by silicon oxide (SiO₂) or by carbonized (i.e. carbon containing) silicon nitride (Si₃N₄). The mentioned materials may thus form the external surface facing the respectively other one of the carrier dielectric and the component dielectric. These materials can be manufactured with extremely smooth surface and may form a CTE-bridge between component carrier and electronic component for at least reducing a CTE mismatch in between.

In an embodiment, the at least one stress release structure comprises an alternating sequence of at least one higher Young modulus layer and at least one lower Young modulus layer. For example, a respective stress release structure may be formed by an alternating sequence of at least four, in particular at least ten, individual layers or layer structures with alternating higher and lower value of the Young modulus. Descriptively speaking, a layer with a lower value of the Young modulus may be more elastic than a layer with a higher value of the Young modulus, i.e. the latter being stiffer. Advantageously, an alternating sequence of more elastic and stiffer layers may combine stress breaking more elastic attributes with stabilizing stiffer characteristics. For example, each individual layer of the alternating sequence may have a thickness in a range from 1 nm to 1 µm, in particular in a range from 10 nm to 100 nm or in a range from 100 nm to 500 nm.

In an embodiment, the at least one higher Young modulus layer comprises at least one silicon layer. Silicon may have a Young modulus in a range from 130 GPa to 170 GPa. To put it shortly, stiff silicon added to an interface between a (in particular silicon-type) electronic component and a (in particular resin- and copper-based) component carrier may provide efficient rigidity while simultaneously reducing a CTE mismatch.

In an embodiment, the at least one lower Young modulus layer comprises at least one silicon oxide layer and/or at least one carbonized silicon nitride layer. The Young modulus of glass or SiO₂ may be 65 GPa to 110 GPa. The Young modulus of substituted polysiloxane (-SiR₂O)ₙ, may be about 0.001 GPa to 1 GPa. Since a lower Young modulus layer may comprise both (glass and polysiloxanes), a range of Young modulus values of the lower Young modulus layer may be from 0.001 GPa to 110 GPa (depending on the composition), preferably from 0.01 GPa to 20 GPa. Descriptively speaking, a soft silicon oxide-based material added to an interface between a (in particular silicon-type) electronic component and a (in particular resin- and copper-based) component carrier may contribute elasticity while reducing a CTE mismatch as well.

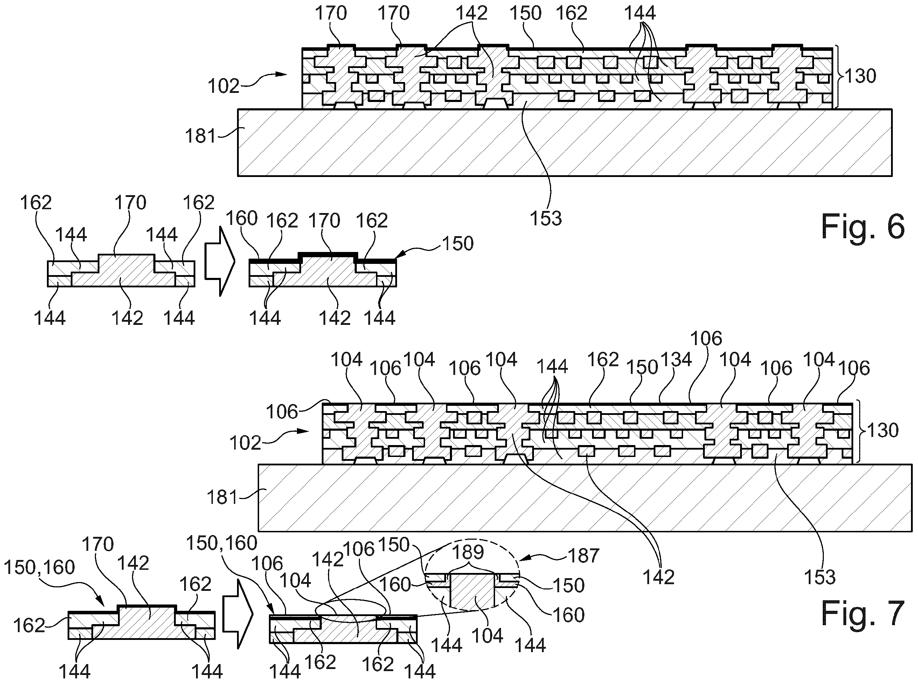

In an embodiment, a portion of a layer provided below (in particular on the side of the stress release structure opposing the external surface facing the component dielectric) one of the at least one stress release structure is exposed with respect to and flushes with the external surface of the respective stress release structure of the at least one of the carrier dielectric or the component dielectric facing the respectively other one of the component carrier dielectric and the component dielectric (see reference sign 189 in Figure 7). In particular, the exposed portion of the layer provided below the one of the stress release structures is provided between the stress release structure and the respective at least one electrically conductive carrier contact or the at least one component pad, in particular encircling the at least one electrically conductive carrier contact or the at least one component pad. Preferably, said layer portion may have a ring shape. Reference is made to Figure 6 and Figure 7. The provision of this exposed portion of the layer provided below one of the at least one stress release structure results in a constant adhesion between said at least one stress release structure and said layer provided below also along the lateral extension (i.e. along the exposed area) of the at least one stress release structure.

In an embodiment, the component carrier comprises an adhesion promoting layer below the stress release structure. Such an adhesion promoting layer may be located on the side of the stress release structure opposed to the external surface facing the component dielectric. Advantageously, the formation of an adhesion promoting layer below the respective stress release structure may ensure that even a highly smooth stress release structure reliably remains on the component carrier without a pronounced tendency of delamination. In an embodiment, the above-mentioned exposed layer is the aforementioned adhesion promoting layer, assuring a strong adhesion also along the the lateral extension (i.e. along the exposed area) of the at least one stress release structure.

In an embodiment, the component carrier comprises a filler free dielectric layer directly below the stress release structure or separated from the stress release structure only by an adhesion promoting layer. Underneath its stress release structure, the component carrier may comprise a (preferably laminated) layer stack which may comprise at least one electrically conductive layer structure and at least one electrically insulating layer. At least a part of said at least one electrically insulating layer structure may for example comprise a resin and optionally filler particles for adjusting properties of the stack, for example thermal conductivity. However, it has turned out that filler particles on the surface of the stack directly below or very close to the stress release structure may lead to an undesired pronounced surface profile directly beneath the stress release structure, which may, in turn, deteriorate its highly smooth surface. Thus, omitting filler particles in the electrically insulating layer structure directly below the stress release structure may contribute to highly desired properties of the stress release structure itself. Moreover, a filler free dielectric layer directly below the stress release structure may also ensure a better compatibility with a plasma etching process which may be executed during manufacturing a package.

In a scenario in which filler particles are strongly needed in the electrically insulating layer structure directly beneath the stress release structure, an amount of filler particles (for instance a weight percentage of filler particles) may be lower in said electrically insulating layer structure than in (in particular all) other electrically insulating layer structures of the stack.

In an embodiment, a connection area between the carrier dielectric and the component dielectric is coplanar with a further connection area between the at least one carrier contact and the at least one component pad. Thus, both the metallic as well as the dielectric connection areas between component carrier and IC-type electronic component may lie in the same plane in the readily manufactured package. This may advantageously suppress undesired phenomena such as delamination or warpage. This may be promoted by one or two stress release structures comprising silicon, because such a material is not prone to shrinkage during processing and will thus not disturb coplanarity.

In an embodiment, the package is free of any material and/or is free of any gap between the component carrier and the electronic component. Hence, there may be neither an air gap nor another material belonging neither to the component carrier nor to the IC-type electronic component in an interface region between component carrier and IC-type electronic component. This may lead to a high compactness in vertical direction and to a simple assembly process.

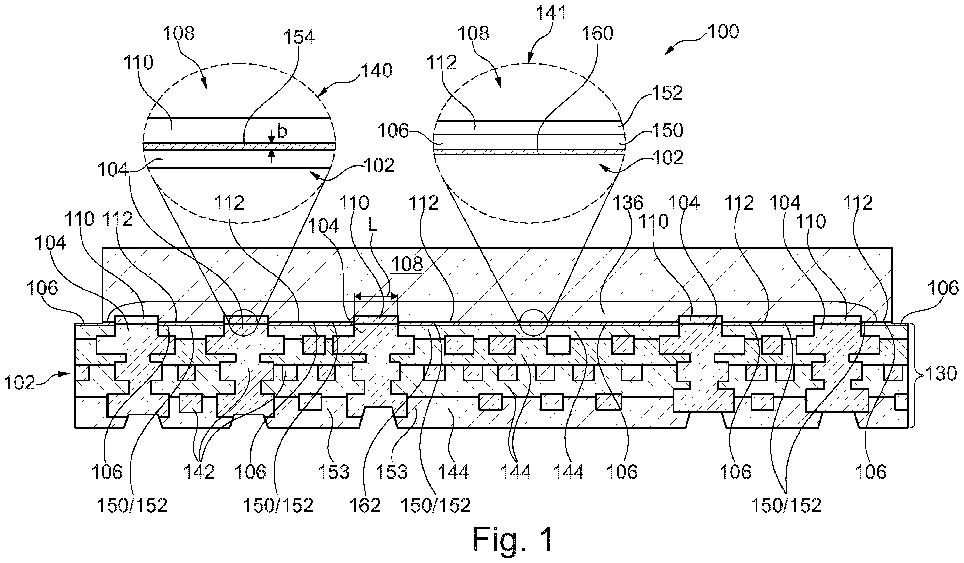

In an embodiment, the component carrier is coreless. A coreless component carrier may be free of a central core having two opposing main surfaces on which a respective build-up may be formed (see for example Figure 1).

In an alternative embodiment, the component carrier comprises a core and a build-up on the core, wherein the build-up faces the electronic component. The above-mentioned stress release structure (for instance having a silicon oxide surface) may be formed on top of the build-up. For example, such a core may comprise cured resin (such as epoxy resin), optionally comprising reinforcing particles (such as glass particles, for instance shaped as spheres). In particular, such a core may be made of FR4 material or glass. A fully cured core may provide high mechanical stability. A build-up may be a laminated layer stack, in particular comprising at least two or even at least four stacked layer structures. Such a build-up may form an appropriate electric interface for the electronic component.

In an embodiment, the component carrier is connected with the electronic component with continuous physical contact over an entire main surface of the electronic component. Hence, no unconnected surface regions of the connection main surface of the IC-type electronic component which might be separated without applying a separation force remains in such an embodiment. Therefore, the reliability of the mutual connection between component carrier and IC-type electronic component may be further improved by taking this measure. Involved connection forces may comprise metal-metal interactions, hydrogen-bond interactions, dipole-dipole interactions, n-n interactions, Van der Waals interactions and/or mixtures thereof.

In an embodiment, the component carrier has a plurality of exposed carrier contacts. Correspondingly, the electronic component may have a plurality of exposed component pads. Each component pad may be connected with an assigned carrier contact. All component pad-carrier contact connections may be established simultaneously. Hence, the component carrier may be connected with the electronic component so that there is a connection, for example with direct physical contact or only with a solder structure in between, between each of the carrier contacts and each respective one of the component pads.

The dimensions, preferably the areas, of the exposed connection pads of the electronic component may be preferably the same. Alternatively, the dimensions, preferably the areas, of the exposed connection pads of the electronic component may be different. The dimensions, preferably the areas, of the exposed carrier contacts of the component carrier may be preferably the same. Alternatively, the dimensions, preferably the areas, of the exposed carrier contacts of the component carrier may be different. Dimensions, preferably the areas, of the opposing connection pads of the electronic component and the carrier contacts of the component carrier may be preferably the same. Alternatively, the dimensions, preferably the areas, of the opposing connection pads of the electronic component and the carrier contacts of the component carrier may be different. Preferably, the silicon comprising portions may be free of a dopant with elements from the third or fifth group of the periodic table in order to maintain non-metallic electrical properties. This may avoid any tendency of silicon layers to create undesired short circuits.

In an embodiment, the component carrier is an integrated circuit substrate. In the context of the present application, the term "integrated circuit substrate" (IC substrate) may particularly denote a component carrier having a size and a pitch adjusted to the requirements of an integrated circuit component (in particular a semiconductor chip) mounted thereon. An IC substrate may be a, in relation to a PCB, comparably small component carrier onto which one or more integrated circuit components may be mounted and that may act as a connection body between one or more chip(s) and a PCB. For instance, an IC substrate may have substantially the same size as an electronic component to be mounted thereon (for instance in case of a Chip Scale Package (CSP)). In another embodiment, the IC substrate may be larger than the assigned component (for instance in a flip chip ball grid array, FCBGA, configuration). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the IC substrate and can be used to provide electrical, thermal and/or mechanical connections of housed components or unhoused components (such as bare dies), particularly of IC chips, with a printed circuit board or interposer. A dielectric part of an IC substrate may be composed of resin with reinforcing particles (such as reinforcing spheres, in particular glass spheres). A pitch, i.e. a distance between corresponding edges of two adjacent metal structures, of an IC substrate may be not more than 150 µm, in particular not more than 100 µm. In contrast to this, a pitch of some kind of PCBs may be at least 200 µm, in particular at least 300 µm.

Alternatively, the component carrier may be a printed circuit board (PCB) .

In an embodiment, the method comprises establishing the connection between the at least one carrier contact and the at least one component pad by contacting the component carrier with the electronic component in combination with heating, in particular to a temperature in a range from 200°C to 300°C. The formation of the metal-metal connection between carrier contact and component pad can thus be promoted by the supply of heat. In particular, this may trigger diffusion soldering, i.e. the formation of a solder connection between component pad and carrier contact when using a thin film of solderable material which may be formed on one (or both) of the component pad and the carrier contact, for instance by plating. For example, such a thin film of solderable material (for example a tin layer or a layer comprising a tin alloy) may have a thickness of less than 20 µm, in particular not more than 10 µm. It is however also possible that a direct metal-metal connection is established by merely contacting the metallic surfaces to be bonded (i.e. without a solder structure in between), supported by heat and/or pressure. Hence, the method may comprise establishing the connection between the at least one carrier contact and the at least one component pad by hybrid bonding or by diffusion soldering. Hybrid bonding may encompass the formation of a direct metal-metal connection promoted by heat and pressure. Diffusion soldering may denote the formation of a solder connection using a thin film solder between two metallic surfaces to be connected, preferably supported by heat and/or pressure.

In an embodiment, the method comprises establishing the connection between the carrier dielectric and the component dielectric by contacting the component carrier with the electronic component at room temperature. Simply establishing a mutual physical contact between carrier dielectric and component dielectric for example at a temperature from 10°C to 30°C, in particular around 20°C, may already trigger oxide bonding between the component dielectric and the carrier dielectric. Such a process may be promoted by the at least one stress release structure constituting the exterior surface of the component dielectric and/or the carrier dielectric, or part thereof. Establishing such a connection between the carrier dielectric and the component dielectric may be done by oxide bonding.

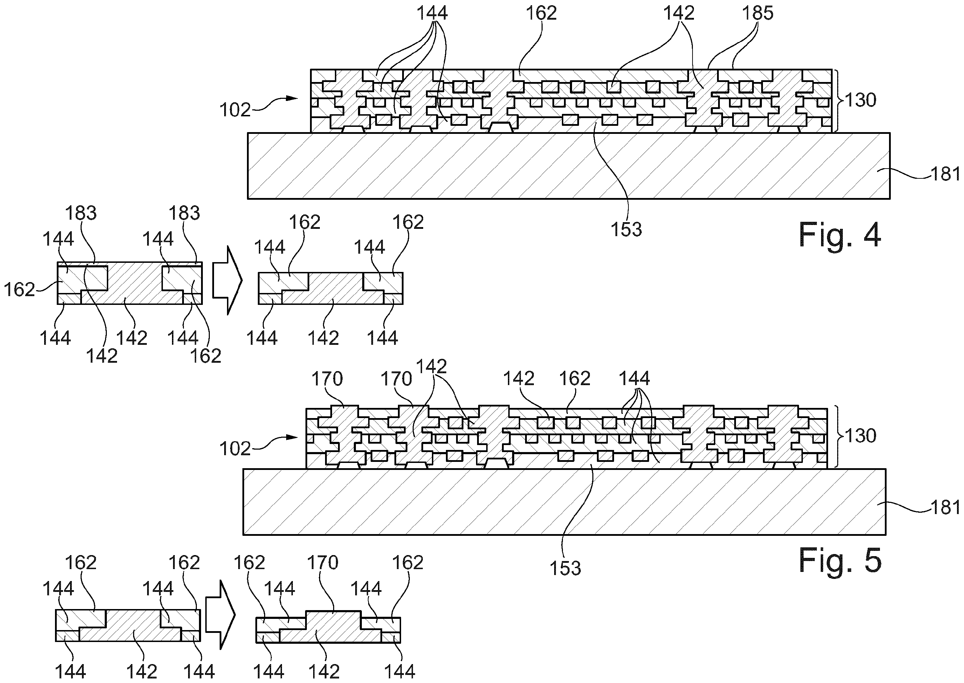

In an embodiment, the method comprises forming the at least one exposed carrier contact based on an electrically conductive protrusion, in particular of a metal pillar, of at least one electrically conductive layer structure of a stack of the component carrier. The protrusion may be formed by removing, in particular by etching, material of at least one electrically insulating layer structure of the stack around the at least one electrically conductive layer structure. For example, Figure 5 shows an etching process for exposing a copper pillar with respect to the surrounding organic laminate material. Thus, the at least one carrier contact may form part of a metal pillar. However, it is also possible that the at least one carrier contact is embodied as at least one carrier pad, for instance formed based on a patterned metal foil or based on a structured plated metal layer.

In an embodiment, the method comprises forming the stress release structure on or above the protrusion and on or above the at least one electrically insulating layer structure around the protrusion. For example, Figure 6 illustrates formation of an initially profiled stress release layer partially above a metallic protrusion and partially above a retracted organic laminate-type dielectric layer structure.

In an embodiment, the method comprises forming an adhesion promoting layer on the protrusion and on the at least one electrically insulating layer structure around the protrusion and below the stress release structure. Thus, an adhesion promoting layer may be sandwiched between a metallic protrusion and an organic laminate-type dielectric layer structure on the one hand and the stress release structure on the other hand. Hence, the adhesion promoting layer may be arranged directly on the dielectric layer and the exposed pillar and directly beneath the stress release structure (see for example Figure 6).

Still referring to the previously described embodiment, the method may comprise planarizing an obtained structure by removing a protruding part of the stress release structure, optionally removing a protruding part of the adhesion promoting layer (if present), and removing a protruding part of the protrusion. Advantageously, such a planarizing process may expose the at least one component contact and may simultaneously increase the flatness of the stress release structure. For example, such a process is shown in Figure 7. This may allow to achieve a small roughness value and a high planarity.

In an embodiment, the package comprises a mounting base, in particular a printed circuit board (PCB), on which the component carrier is mounted. Such a mounting base may connect the component carrier and its surface mounted component(s) mechanically and electrically with an electronic periphery.

In an embodiment, the component carrier comprises a stack which comprises at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one further component may be embedded in and/or surface mounted on the stack. The at least one further component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the further component may also be an IC substrate, an interposer or a further component carrier, for example in a board-in-board configuration. The further component may be surface mounted on the component carrier and/or may be embedded in an interior thereof.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

In an embodiment, the component carrier related body is a laminate-type component carrier. In such an embodiment, the component carrier is a compound of multiple layer structures which are stacked and connected together by applying a pressing force and/or heat.

The aspects defined above and further aspects of the invention are apparent from the examples of embodiment to be described hereinafter and are explained with reference to these examples of embodiment.
Figure 1 illustrates a cross-sectional view of a package according to an exemplary embodiment of the invention.
Figure 2 to Figure 9 illustrate cross-sectional views of structures obtained during carrying out a method of manufacturing a package according to an exemplary embodiment of the invention, such as the one shown in Figure 9 or the one shown in Figure 1.
Figure 10 and Figure 11 illustrate cross-sectional views of structures obtained during carrying out a method of manufacturing a package according to another exemplary embodiment of the invention.
Figure 12 illustrates a cross-sectional view of a stress release structure of a component carrier for a package according to an exemplary embodiment of the invention.
Figure 13 illustrates cross-sectional views of structures obtained during carrying out a method of manufacturing a package according to another exemplary embodiment of the invention.
Figure 14 illustrates cross-sectional views of structures obtained during carrying out a method of manufacturing a package according to another exemplary embodiment of the invention.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

According to an exemplary embodiment of the invention, a package is composed of a component carrier (such as an IC substrate or alternatively a PCB) and one or more surface mounted and/or embedded (in particular electronic) components. Advantageously, the component carrier is connected with the electronic component so that there is a connection between a carrier contact of the component carrier and a component pad of the electronic component. In addition, the connection between component carrier and electronic component may be accomplished to create a direct physical contact between a carrier dielectric of the component carrier and a component dielectric of the electronic component. Advantageously, the carrier dielectric and/or the component dielectric is equipped with a stress release structure at its exposed surface facing the other one of the carrier dielectric and the component dielectric. By taking this measure, electronic component and component carrier may be connected directly (in particular by hybrid bonding), wherein one or two stress release structures may buffer stress directly in between electronic component and component carrier. This may efficiently suppress delamination or separation tendencies between electronic component and component carrier and may protect against cracks and warpage. Consequently, a package with high reliability and stress resistance may be obtained. For instance, a stress release structure on the component carrier may comprise silicon and/or silicon oxide on an organic layer stack. CTE mismatch of the component carrier with respect to a semiconductor-based electronic component may thereby be reduced, and the high flatness of such a stress release structure may promote a high connection strength between component carrier and electronic component. Furthermore, a proper management of the values of the Young modulus of the stress release structure with respect to adjacent material of component carrier and electronic component may allow to obtain a highly reliable package.

In particular, an adaptation of the properties of the constituents of the package by the at least one stress release structure in between may be accomplished via adjusting the coefficient of expansion and the Young modulus between the (preferably inorganic) stress release structure and the organic laminate. This may be achieved by using layered materials in a gradual manner via a gradient match from one material to another. Used layers may include glass and resin systems or a resin layer like SiO₂, silicone-SiO₂, or silicon nitride. For example, silicon may be powerful to reduce stress between SiO₂ layers. Organosilicate may be converted into a silicone or SiO₂ during coating, depending on the process parameters.

For example, oxide bonding may be accomplished by adjusting the layer material (which may be formed and adjusted by using CVD, chemical vapor deposition) and diffusion soldering (for example at a temperature of about 220°C) and the die (with copper).

Advantageously, a package according to an exemplary embodiment of the invention may interconnect component carrier and electronic component by using a hybrid bonding capable substrate, which can be assembled directly with the semiconductor component. Advantageously, no underfill is necessary between component carrier and electronic component, since it may be possible to connect component carrier with electronic component without gap in between. Further advantageously, a chip last method may be executed which may improve yield, since the electronic component may be mounted on the component carrier at the very end of the manufacturing process by hybrid bonding.

By embodiments of the invention, a compound organic laminate may be connected with a die as electronic component. This may have a positive effect on signal transmission in view of the obtainable short connections, the option to provide a redistribution layer, and the absence of foreign materials. Furthermore, the described manufacturing architecture may simplify the carrier-component connection. Advantageously, an organic substrate may be used for hybrid bonding.

Advantageously, an organic substrate is properly compatible with a hybrid bonding process. Further advantageously, no silicon interposer is required which may render the package compact. Furthermore, no additional connecting material is required, in particular no underfill.

To put it shortly, direct hybrid bonding of two substrates (i.e. a component carrier and an electronic component) may be executed at room temperature without using any adhesive. The bonded structure may exhibit formation of conductor-to-conductor bonds, and creation of dielectric-to-dielectric hybrid bonds (which may be based on Van der Waals forces).

Contrary to conventional approaches, a direct connection between component carrier and electronic component mediated by at least one stress release structure at a mutual interface may render a separate silicon interposer or the like dispensable. In conventional approaches, an additional silicon interposer may carry a silicon die and may be mounted on a mounting base. Omitting such an additional silicon interposer may render a package according to an exemplary embodiment more compact. Furthermore, the direct connection between component carrier and electronic component may enable formation of very fine lines, even in an interconnection region. Preferably, an organic substrate-type component carrier may be equipped with a highly smooth dielectric surface material in form of a stress release structure which may undergo oxide bonding upon contact with the component carrier. Moreover, facing carrier contacts of the component carrier and component pads of the electronic component may be connected by hybrid bonding, in particular forming a direct metal-metal bond between carrier contacts and component pads. When providing solderable material (which may comprise or consist of tin) on the carrier contacts and/or on the component pads (any or both of which may be made of copper), preferably in form of a thin film of solderable material, a metal-metal bond may be created by diffusion soldering.

Highly preferably, exposed silicon oxide of a respective stress release structure at an exterior surface of an exposed carrier dielectric and/or of an exposed component dielectric may reduce stress exerted to the connected parts. In particular, construction of such one or two stress release structures may allow to at least partially balance a CTE mismatch between component carrier (for instance formed based on organic laminate and copper) and electronic component (for example formed based on silicon). Furthermore, such at least one stress release structure may allow to adjust the Young modulus (for example by providing an alternating sequence of more elastic and stiffer materials) for reducing stress.

For establishing a connection between component carrier and electronic component, a hybrid bonding process may be carried out. For example at ambient or room temperature, oxide bonding between an exposed carrier dielectric and an exposed component dielectric may be carried out, for instance by connecting exposed silicon oxide layers of stress release structures of component carrier and electronic component with each other. For example subsequently, a metal-metal bonding (for example a copper-copper bonding) between at least one carrier contact and at least one component pad may be created by a mechanical contact in combination with heating (for example up to a maximum temperature in a range from 200°C to 300°C). When providing solderable material in between, the metal-metal bond may be formed by diffusion soldering.

**Figure 1** illustrates a cross-sectional view of a package 100 according to an exemplary embodiment of the invention.

The illustrated package 100 comprises a component carrier 102 and comprises an electronic component 108 mounted with full-surface direct physical contact on the component carrier 102. Alternatively, a number of electronic components 108 being surface mounted on the component carrier 102 may be at least two. Additionally or alternatively to the surface mounted component 108, it is also possible to embed one or more electronic components 108 in the component carrier 102 by establishing a connection as described herein for the connection between component carrier 102 and surface mounted electronic component 108.

For example, the component carrier 102 may comprise or consist of a laminated layer stack 130 comprising a plurality of electrically conductive layer structures 142 and of electrically insulating layer structures 144. The electrically conductive layer structures 142 may comprise patterned copper layers which may form horizontal pads and/or a horizontal wiring structure. Additionally or alternatively, the electrically conductive layer structures 142 may comprise vertical through connections such as copper pillars and/or copper filled laser vias. Moreover, the stack 130 of the component carrier 102 may comprise one or more electrically insulating layer structures 144 (such as prepreg or resin sheets). Also surface finish (like ENIG or ENEPIG), a solder resist, etc. may be applied. The lowermost electrically insulating layer structure 144 in Figure 1 is embodied as a solder resist 153. The solder resist 153 may support correct soldering of component carrier 102 on a mounting base below (not shown).

The integrated circuit component 108 is here configured as bare die (i.e. non-encapsulated semiconductor chip) and is surface mounted on a top main surface of the component carrier 102. The IC component 108 may be configured as semiconductor chip, for instance active semiconductor chip. Examples of the IC-type electronic component 108 are processors, memories, sensors, logic chips, microelectromechanical systems (MEMS), etc. The electronic component 108 may comprise an integrated circuit 136 with at least one monolithically integrated circuit element, such as a transistor or a diode, in an active region. The IC component 108 can also be a stacked IC, a module, a chiplet or a system-on-chip (SOC).

Details 140, 141 in Figure 1 shows particularities of the connection surface between the component carrier 102 and the electronic component 108. To put it shortly, detail 140 illustrates a metal-metal bond between component carrier 102 and electronic component 108 created by diffusion soldering. Detail 141 illustrates a silicon oxide-silicon oxide bond between component carrier 102 and electronic component 108 created by oxide bonding. As also shown in details 140, 141, the package 100 is free of any material and is free of any gap between the component carrier 102 and the electronic component 108 which are connected with each other over a continuous connection area. Thus, the component carrier 102 may be connected with the electronic component 108 with continuous physical contact over an entire main surface of the electronic component 108.

Still referring to Figure 1 and in particular to details 140, 141, the component carrier 102 comprises in its upper portion a plurality of exposed carrier contacts 104 being surrounded by a stress release structure 150 of an exposed carrier dielectric 106. For instance, each of the carrier contacts 104 is made of copper. The exposed surface of the stress release structure 150 may comprise or consist of silicon oxide or glass. In the connected state according to Figure 1, exterior planar surface portions of the exposed stress release structure 150 and of the exposed carrier contacts 104 may be coplanar and at the same vertical level. The avoidance of protrusions and depressions in the substantially flat connection surface between component carrier 102 and electronic components 108 may ensure a reliable electric connection as well as an avoidance of cracks.

Still referring to details 140, 141, the illustrated electronic component 108 has exposed component pads 110 and has an exposed component dielectric 112. For instance, each of the component pads 110 is made of copper. Advantageously, the material of the carrier contacts 104 and of the component pads 110 may be the same which may promote a firm connection and thus a good reliability of package 100. The exposed component dielectric 112 may be formed by stress release structure 152 which may comprise or consist of silicon oxide or glass.

In the connected state according to Figure 1, exterior planar surface portions of the exposed component dielectric 112 and of the exposed component pads 110 may be coplanar, i.e. at the same vertical level. Furthermore, exterior planar surface portions of the exposed component pads 110 and of the exposed carrier contacts 104, one of which having an optional thin film solder structure 154 thereon, may be coplanar and at the same vertical level as dielectrics 106, 112. Hence, a connection area between the stress release structure 150 of the carrier dielectric 106 and a stress release structure 152 of the component dielectric 112 is coplanar with a further connection area between the carrier contact 104 and the component pad 110. Although stress release structures 150, 152 are formed on both facing connection surfaces of component carrier 102 and electronic component 108 in the embodiment of Figure 1, it is alternatively also possible that only one stress release structure 150 or 152 is present. Optionally, one or both of the carrier contact 104 and the component pad 110 may be provided with thin film-type solder structure 154 (for instance a solderable material, for example comprising or consisting of tin) supporting diffusion soldering. For example, thin film-type solder structure 154 may have a thickness, b, in a range from 1 µm to 10 µm.

As shown in detail 140 as well, the component carrier 102 is connected with the illustrated electronic component 108 so that there is a connection between the carrier contacts 104 and the component pads 110 only via thin film-type solder structure 154 in between. Since thin film-type solder structure 154 is optional, it is also possible in other embodiments that a direct physical connection is established between the copper carrier contacts 104 and the copper component pads 110. As shown in detail 141, the connection is established so that there is a direct physical contact between the carrier dielectric 106 and the component dielectric 112. Advantageously, no additional element (for instance an interposer) is arranged between the component carrier 102 and the electronic component 108. This keeps the vertical dimension of package 100 small so that a compact design may be achieved. Furthermore, this connection characteristics keeps the electric connection paths short, thereby ensuring high signal integrity and low losses as well as a strong suppression of excessive package heating. Consequently, package 100 may be provided with high thermal, mechanical and electrical reliability.

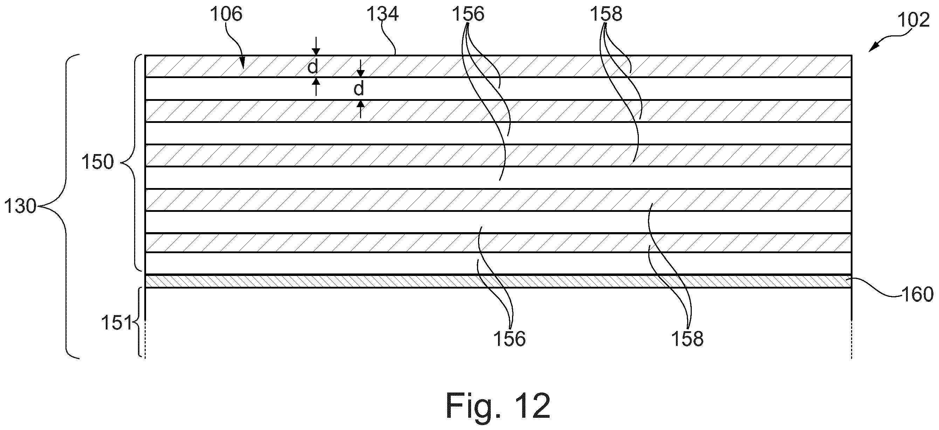

In the illustrated embodiment, the exposed carrier dielectric 106 can also be formed by a thin layer stack in form of stress release structure 150, which can be preferably a layer sequence of alternating silicon oxide and silicon layers. The stress release structure 150 may be arranged on organic stack 130 of the component carrier 102. By forming the exposed carrier dielectric 106 with a very smooth thin stress release structure 150, excellent connection properties between component carrier 102 and the respective IC-type electronic component 108 may be achieved. Stress release structure 150 may accomplish an at least partial CTE mismatch compensation between component carrier 102 and electronic component 108. Furthermore, stress release structure 150 may provide a proper balance between elasticity (or softness) and stiffness at the interface between component carrier 102 and electronic component 108, for instance when being embodied as shown in Figure 12.

For example, a lateral extension, L, of each of the carrier contacts 104 and the component pads 110 may be less than 25 µm. The described manufacturing architecture allows to connect a component carrier 102 and electronic components 108 with very small pad dimensions.

What concerns the interior construction of the component carrier 102, it may be configured as a coreless substrate. More specifically, stack 130 of component carrier 102 may comprise laminated electrically insulating layer structures 144 and electrically conductive layer structures 142, but no core.

Although not shown, component carrier 102 may comprise alternatively a central core, a top-sided build-up on an upper main surface of the core, and a bottom-sided build-up on a lower main surface of the core. While the top-sided build-up faces the electronic component 108, the bottom-sided build-up faces a bottom-sided mounting base, such as a PCB. Preferably, the component-sided build-up has a higher integration density than the core and than the bottom-sided build-up. Hence, a locally higher integration density may be formed next to the surface mounted IC component 108 having a higher integration density as well. However, a lower integration density may be sufficient or desired next to the mounting base with its lower integration density. This may allow to manufacture the component carrier 102 with low effort and to provide one or more regions of higher integration density only where needed. For instance, any of the optional build-ups may contribute to a mechanical strengthening and/or the formation of a redistribution layer in the framework of the package.

Now again referring to Figure 1, each of the carrier dielectric 106 and the component dielectric 112 comprises a stress release structure 150, 152 at its surface facing the respectively other one of the carrier dielectric 106 and the component dielectric 112. Each stress release structure 150, 152 may have an extremely small surface roughness Ra of preferably less than 10 nm, most preferably less than 1 nm. This ensures very smooth and flat connection surfaces and therefore a highly reliable delamination-free connection between component carrier 100 and electronic component 108. Preferably, an exterior surface of each of the stress release structures 150, 152 is formed by silicon oxide (SiO₂). Alternatively, an exterior surface of a respective one of the stress release structures 150, 152 may be carbonized silicon nitride (i.e. Si₃N₄ with added carbon).

Advantageously, the component carrier 102 comprises a filler free dielectric layer 162 (which may be an organic layer) directly below the stress release structure 150. Other electrically insulating layer structures 142 of stack 130 may comprise filler particles, for instance for enhancing thermal conductivity and/or for enhancing stability. However, it has been found that the presence of filler particles in the uppermost dielectric layer 162 of stack 130 may disturb the high smoothness and small roughness Ra of the stress release structure 150 on top of the uppermost dielectric layer 162. To put it shortly, configuring the dielectric layer 162 filler free may have a positive impact on the connection strength between component carrier 102 and electronic component 108. Preferably, the filler free dielectric layer 162 may be arranged directly next to the stress release structure 150, or may be separated from the stress release structure 150 only by an adhesion promoting layer 160 (see Figure 6).

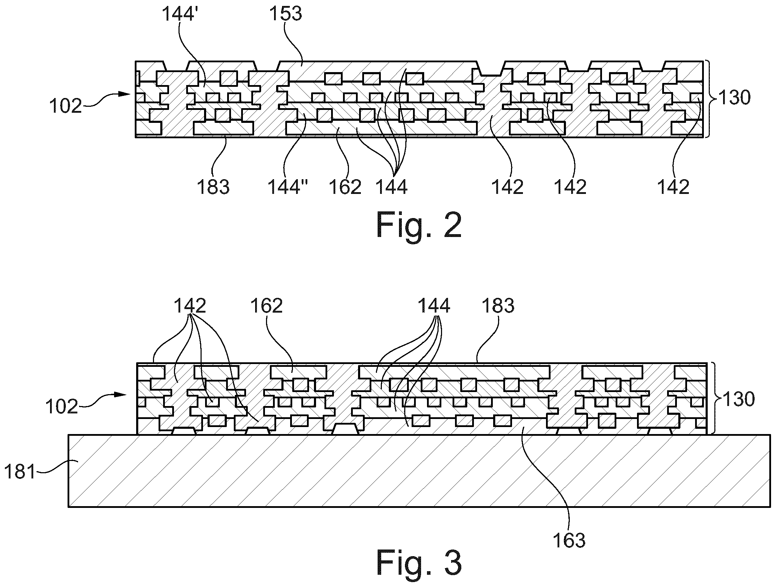

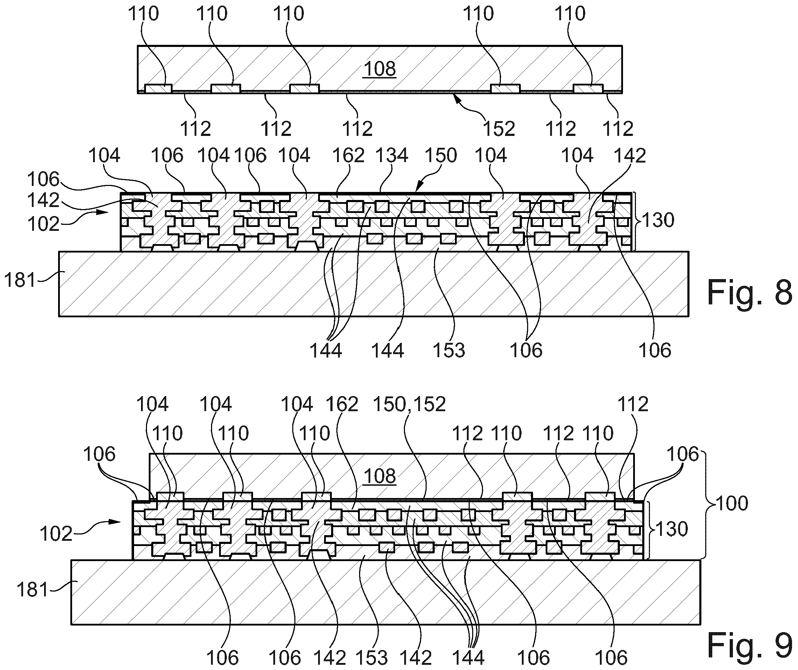

Figure 2 to Figure 9 illustrate cross-sectional views of structures obtained during carrying out a method of manufacturing a package 100 according to an exemplary embodiment of the invention, as the one shown in Figure 1 or the one shown in Figure 9.

As shown in **Figure 2****,** a component carrier 102 is provided with a stack 130 comprising copper-type electrically conductive layer structures 142 and organic electrically insulating layer structures 144, as described above referring to Figure 1. According to Figure 2, component carrier 100 is embodied as coreless substrate. Solder mask 153 may be configured so as to be temperature stable during hybrid bonding for forming metal-metal bonds. Alternatively, solder mask 153 may also be applied after hybrid bonding or may be omitted.

Many options exist for the electrically insulating layer structures 144. For example, electrically insulating layer structure 144' may be formed as photoimageable dielectric (PID). Electrically insulating layer structure 144" may be formed as resin layer comprising filler particles for enhancing thermal conductivity. Electrically insulating layer structure 162 may be formed without filler particles (or with a locally reduced weight percentage of filler particles), which may strengthen the later formed connection between component carrier 100 and electronic component 108. A thin metal film 183 (for example a copper film) may be formed on the electrically insulating layer structure 162.

Referring to **Figure 3****,** the structure shown in Figure 2 may be turned upside down and may be mounted on a temporary carrier 181. Preferably, temporary carrier 181 should be temperature resistant up to at least 300°C so as to withstand a subsequent bonding temperature.

Referring to **Figure 4****,** the structure shown in Figure 3 is treated for removing metal film 183 and for planarizing the upper main surface. This may be accomplished for example by chemical mechanical polishing (CMP). As a result, an upper main surface 185 may be obtained which has a flat characteristic with a roughness Ra of less than 5 nm.

As an alternative to CMP, the structure shown in Figure 4 may also be obtained by flash etching. Care should be taken to avoid a dimple on the top side, which may be achieved by properly selecting the etching parameters.

In order to obtain the structure shown in **Figure 5****,** the structure shown in Figure 4 may be subjected to an etching process for selectively removing dielectric surface material, but not metal. For instance, this may be accomplished by plasma etching. For example, a dielectric thickness of not more than 1 µm may be removed by said etching process. As a result, copper pillars may be exposed which may later form the basis of exposed carrier contacts 104 of component carrier 102 for forming a metal-metal connection with an electronic component 108.

More generally, the later exposed carrier contacts 104 may be formed based on pillar-type electrically conductive protrusions 170 of the uppermost electrically conductive layer structure 142 of stack 130. Forming the protrusion 170 may be accomplished by etching away material of an electrically insulating layer structure 144 of the stack 130 around the electrically conductive layer structure 142.

Now referring to **Figure 6****,** an adhesion promoting layer 160 is formed on the protrusions 170 and on an exposed part of the electrically insulating layer structure 144 around the protrusions 170. For example, the adhesion promoting layer 160 may be formed based on silane. A thickness of the adhesion promoting layer 160 may be in a range from 1 nm to 200 nm, for example 100 nm. Advantageously, the adhesion promoting layer 160 may promote adhesion of a subsequently formed stress release structure 150. Although adhesion promoting layer 160 is optional, it is highly advantageous to improve adhesion of an ultra-flat and ultra-smooth stress release structure 150. The ultra-flat and ultra-smooth properties - i.e. a very small roughness Ra of for example less than 5 nm - of the latter may be highly advantageous for a reliable connection between component carrier 102 and electronic component 108, however may be challenging in terms of adhesion. Thus, the presence of an adhesion promoting layer 160 directly beneath the stress release structure 150 may be of utmost advantage.

After having formed the adhesion promoting layer 160, the method can be continued by forming the stress release structure 150 on the adhesion promoting layer 160 and above the protrusions 170 as well as above the uppermost electrically insulating layer structure 144 around the protrusions 170. The stress release structure 150 may comprise one or more silicon oxide layers. For example, such a silicon oxide layer may be formed by chemical vapor deposition (CVD). For instance, the stress release structure 150 may have a thickness in a range from 1 µm to 30 µm, in particular in a range from 2 µm to 10 µm.

As can be taken from **Figure 7****,** the structure shown in Figure 6 is then planarized, for example by CMP. As a result, a protruding part of the stress release structure 150, a protruding part of the adhesion promoting layer 160, and a protruding part of the protrusion 170 are removed. Advantageously, a surface with a very low surface roughness Ra may be obtained, for instance 2 nm or even 0.1 nm. As a result, carrier dielectric 106 with exteriorly exposed stress release structure 150 is obtained and surrounds an exposed carrier contact 104.

Referring to a detail 187 in Figure 7, after the planarizing process, a portion 189 of the adhesion promoting layer 160 remaining below the stress release structure 150 may be exposed with respect to and may flush with the external surface of the stress release structure 150. Said exposed portion 189 of the adhesion promoting layer 160 may be provided between the stress release structure 150 and the electrically conductive carrier contact 104 and may encircle or surround the latter.

Referring to **Figure 8****,** an electronic component 108 is provided which is to be connected with the component carrier 102 processed as described above. The illustrated semiconductor die-type electronic component 108 has a monolithically integrated circuit 136 (not shown in Figure 8, see Figure 1) in a semiconductor body of the electronic component 108. The electronic component 108 comprises exposed component pads 110 (for instance made of copper) and an exposed component dielectric 112. Advantageously, also the component dielectric 112 has an exterior surface defined by a stress release structure 152 at its surface facing the carrier dielectric 106 during connection. Stress release structure 152 may be constructed as stress release structure 150. However, for optimal stress release, stress release structure 150 may be configured specifically for stress release of component carrier 102, whereas stress release structure 152 may be specifically configured for stress release of electronic component 108. Together, stress release structures 150, 152 may provide CTE mismatch adjustment and Young modulus management for strongly suppressing connection stress between electronic component 108 and component carrier 102. The facing surfaces of stress release structures 150, 152 may each have a very small roughness Ra, for instance not more than 10 nm, preferably not more than 1 nm. This may ensure a reliable connection between electronic component 108 and component carrier 102.

Correspondingly, the facing surfaces of carrier contacts 104 and component 110 may each have a very small roughness Ra, for instance not more than 10 nm. This may also contribute to a reliable connection between electronic component 108 and component carrier 102. Preferably, carrier contacts 104 and component pads 110 may be made of the same metallic material, such as copper.

To put it shortly, the opposing connection surfaces of component carrier 102 (i.e. the spatial arrangement and material composition of carrier contacts 104 and stress release structure 150) and electronic component 108 (i.e. the spatial arrangement and material composition of component pads 110 and stress release structure 152) may be preferably identical. However, they may also be constructed individually and differently.

Before contacting the component carrier 102 with the electronic component 108 for establishing a connection, it may be possible to subject the connection surfaces (i.e. the exposed surfaces according to reference signs 150, 152, 104, 110) to surface activation, for example by plasma activation. This may further improve the adhesion between the connection surfaces

In order to obtain package 100 shown in **Figure 9****,** the component carrier 102 may be connected with the electronic component 108 so that there is a direct physical contact between the carrier contacts 104 and the component pads 110 and so that there is a direct physical contact between the stress release structure 150 of the carrier dielectric 106 and the stress release structure 152 of the component dielectric 112. Connection between component carrier 102 and electronic component 108 may be supported by a die bonder (not shown).

More specifically, establishing the connection between the carrier contacts 104 and the component pads 110 may be carried out by contacting the component carrier 102 with the electronic component 108 in combination with heating preferably to a temperature in a range from 200°C to 300°C. Thus, establishing the connection between the carrier contacts 104 and the component pads 110 may be carried out for creating a direct copper-copper connection by hybrid bonding (or by diffusion soldering, as described referring to Figure 1).

Correspondingly, establishing the connection between the stress release structure 150 of the carrier dielectric 106 and the stress release structure 152 of the component dielectric 112 may be accomplished by contacting the component carrier 102 with the electronic component 108. This may be done even at room temperature. Hence, establishing the connection between the carrier dielectric 106 and the component dielectric 112 may be done by oxide bonding.

The structure shown in Figure 9 may be subjected to an annealing process, for instance at a temperature of 300°C. At the end of the manufacturing process, package 100 may be removed from the temporary carrier 181.

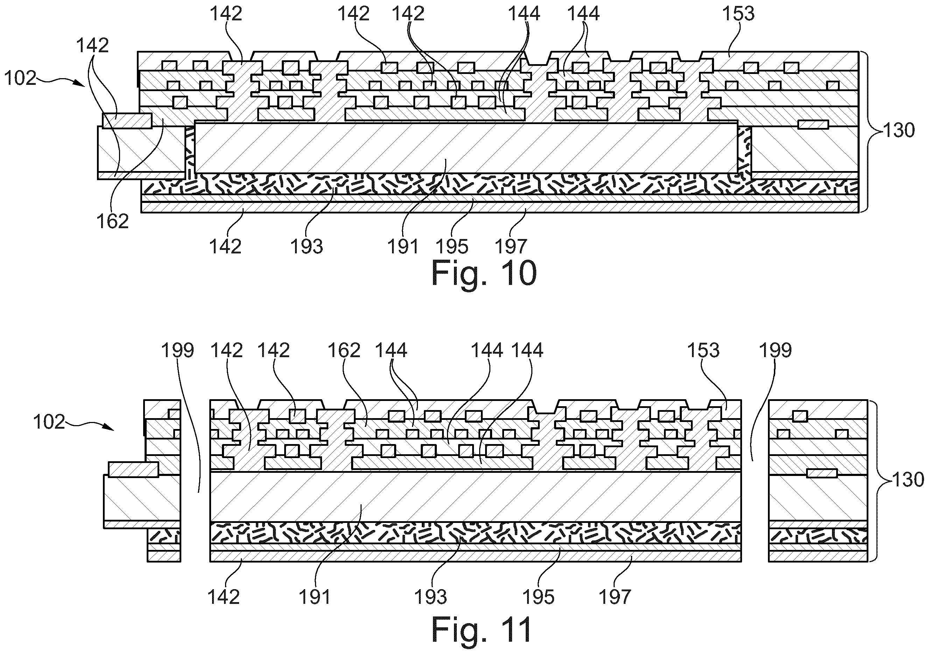

**Figure 10** and **Figure 11** illustrate cross-sectional views of structures obtained during carrying out a method of manufacturing a package 100 according to another exemplary embodiment of the invention.

The stack 130 according to Figure 10 differs from stack 130 according to Figure 2 in particular in that, according to Figure 10, the bottom side is equipped additionally with a glass carrier 191 embedded in a prepreg layer 193. Below the prepreg layer 193, a further resin layer 195 and a further metal foil 197 may be arranged. Hence, Figure 10 shows another embodiment of a coreless substrate which may be used for manufacturing a component carrier 102 according to an exemplary embodiment of the invention.

Figure 11 shows the stack 130 according to Figure 10 after forming through holes 199.

**Figure 12** illustrates a cross-sectional view of a stress release structure 150 of a component carrier 102 for a package 100 according to an exemplary embodiment of the invention.

Figure 12 shows an exterior portion of a layer stack 130 of component carrier 102, such as an IC substrate, to be connected with an electronic component 108 (not shown in Figure 12) at exposed surface area 134. Stack 130 may be composed of a bottom-sided build-up 151, for instance one or more electrically conductive layer structures 142 and/or electrically insulating layer structures 144 (not shown in Figure 12), and top-sided and exposed stress release structure 150.

As shown in Figure 12, the exposed stress release structure 150 is configured as an alternating sequence of a plurality of higher Young modulus layers 156 and a plurality of lower Young modulus layers 158. The higher Young modulus layers 156 are made of a material having a higher value of the Young modulus than another material of the lower Young modulus layers 158 having a lower value of the Young modulus than the higher Young modulus layers 156. To put it shortly, the higher Young modulus layers 156 are stiffer than the lower Young modulus layers 158. In other words, the lower Young modulus layers 158 are more elastic than the higher Young modulus layers 156. Preferably, the higher Young modulus layers 156 may comprise or consist of silicon (Si). Silicon may have a Young modulus in a range from 130 GPa to 170 GPa. The lower Young modulus layers 158 may comprise or consist of silicon oxide (in particular SiO₂). The Young modulus of glass or SiO₂ may be 65 GPa to 110 GPa. It is also possible that the lower Young modulus layers 158 comprise both glass and polysiloxanes. The Young modulus of substituted polysiloxane (-SiR₂O)ₙ may be about 0.001 GPa to 1 GPa. Thus, a range of Young modulus values of the lower Young modulus layers 158 may be from 0.001 GPa to 110 GPa (depending on the composition), preferably 0.01 GPa to 20 GPa.

A thickness, d, of any of the layers 156, 158 may for example be in a range from 1 nm to 100 nm, for instance 20 nm. Different layers 156, 158 may have different thicknesses or may all have the same thickness.

Advantageously, the exposed surface area 134 may have an extremely small roughness Ra, for example not more than 100 nm, preferably not more than 10 nm for instance 1 nm. Glass can be formed with such an extremely small roughness. Hence, the exposed surface area 134 of the component carrier 102 may be very smooth and flat, which may promote a low-stress connection with a semiconductor die-type electronic component 108 (not shown in Figure 12) by hybrid bonding.

Descriptively speaking, the smooth and soft silicon oxide-based material of exterior layer 158 in combination with the stiffer layers 156 and the alternating characteristic of thin-film layers 156, 158 may combine elasticity with stability while reducing a CTE mismatch and providing an extremely smooth connection surface. More specifically, silicon material works efficiently for damping stress. In addition, silicon oxide can be deposited with ultra-smooth properties. Hence, the combination of silicon and silicon oxide may provide excellent properties in terms of stress release in an interface region between a component carrier 102 and an electronic component 108.

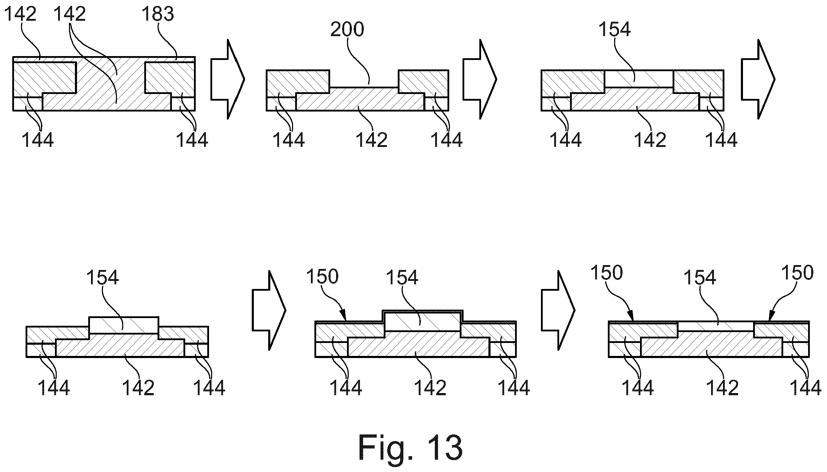

**Figure 13** illustrates cross-sectional views of structures obtained during carrying out a method of manufacturing a package 100 according to another exemplary embodiment of the invention. The arrows in Figure 13 indicate a process flow. Figure 13 illustrates manufacture of a component carrier 102.

The first image of Figure 13 corresponds to a structure as already shown and described referring to Figure 4. The second image in Figure 13 shows the first image after removal of metal film 183 and after having formed a cavity 200 by removing metallic material of exposed pillar-type electrically conductive layer structure 142. The third image of Figure 13 shows that cavity 200 has been filled with a solder depot to thereby cover the exposed electrically conductive layer structure 142 with solder structure 154. The fourth image of Figure 13 shows the third image after removing exposed dielectric surface material. The fifth image of Figure 13 illustrates the fourth image after having formed stress release structure 150 on the exposed surface. Preferably, an adhesion promoting layer 160 (not shown in Figure 13) may be formed directly beneath stress release structure 150 to enhance its adhesion on stack 130. The last image of Figure 13 shows the fifth image after planarizing the upper main surface, thereby exposing solder structure 154.

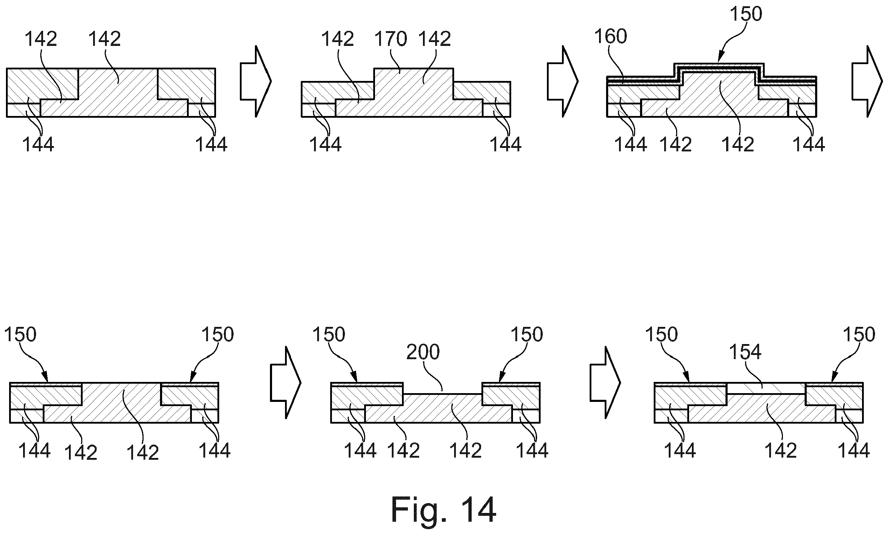

**Figure 14** illustrates cross-sectional views of structures obtained during carrying out a method of manufacturing a package 100 according to another exemplary embodiment of the invention. The arrows in Figure 14 indicate a process flow. Figure 14 illustrates manufacture of a component carrier 102.

The first four images of Figure 14 corresponds to the process flow which has been described referring to Figure 4 to Figure 7. The fifth image in Figure 14 shows the fourth image after removing metallic material of exposed pillar-type electrically conductive layer structure 142 and thereby creating a cavity 200. The last image in Figure 14 is obtained by filling the cavity 200 with a solder structure 154, for instance by plating.

The last images of Figure 13 and Figure 14 show structures which are appropriate for establishing a solder connection between carrier contacts 104 of component carrier 102 and component pads 110 of electronic component 108, while creating a connection by oxide bonding between facing stress release structures 150, 152.

It should be noted that the term "comprising" does not exclude other elements or steps and the "a" or "an" does not exclude a plurality. Also, elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants is possible which use the solutions shown and the principle according to the invention even in the case of fundamentally different embodiments.

## Claims

1. A package (100), wherein the package (100) comprises:
a component carrier (102) having at least one exposed electrically conductive carrier contact (104) and having an exposed carrier dielectric (106); and
an electronic component (108) having an integrated circuit (136), having at least one exposed component pad (110) and having an exposed component dielectric (112);
wherein the component carrier (102) is connected with the electronic component (108) so that there is a connection between the at least one carrier contact (104) and the at least one component pad (110) and so that there is a direct physical contact between the carrier dielectric (106) and the component dielectric (112); and
wherein at least one of the carrier dielectric (106) and the component dielectric (112) comprises a stress release structure (150, 152) at its surface facing the respectively other one of the carrier dielectric (106) and the component dielectric (112).

2. The package (100) according to claim 1, comprising at least one of the following features:
wherein the component carrier (102) comprises an organic dielectric;
wherein the component carrier (102) is connected with the electronic component (108) so that there is a direct physical contact between the at least one carrier contact (104) and the at least one component pad (110);
wherein the connection between the at least one carrier contact (104) and the at least one component pad (110) is provided by a solder structure (154) in between.

3. The package (100) according to any of claims 1 to 2, wherein the at least one stress release structure (150, 152) has a surface roughness Ra of less than 1 µm, in particular less than 10 nm, more particularly less than 1 nm.

4. The package (100) according to any of claims 1 to 3, wherein an exterior surface of the at least one stress release structure (150, 152) is formed by silicon oxide or by carbonized silicon nitride.

5. The package (100) according to any of claims 1 to 4, wherein a portion (189) of a layer provided below one of the at least one stress release structure (150, 152) is exposed with respect to and flushes with the external surface of the respective stress release structure (150, 152) of the at least one of the carrier dielectric (106) or the component dielectric (112) facing the respectively other one of the carrier dielectric (106) and the component dielectric (112).

6. The package (100) according to claim 5, wherein the exposed portion (189) of the layer provided below one of the stress release structure (150, 152) is provided between the stress release structure (150) and the respective at least one electrically conductive carrier contact (104) or the at least one component pad (110), in particular encircling the at least one electrically conductive carrier contact (104) or the at least one component pad (110).

7. The package (100) according to any of claims 1 to 6, wherein the component carrier (102) comprises an adhesion promoting layer (160) below the stress release structure (150).

8. The package (100) according to claim 7 when depending to any of the claims 5 or 6, wherein the exposed layer is the adhesion promoting layer (160).

9. The package (100) according to any of claims 1 to 8, wherein the component carrier (102) comprises a filler free dielectric layer (162) directly below the stress release structure (150) or separated from the stress release structure (150) only by an adhesion promoting layer (160).

10. The package (100) according to any of claims 1 to 9, wherein a connection area between the carrier dielectric (106) and the component dielectric (112) is coplanar with a further connection area between the at least one carrier contact (104) and the at least one component pad (110).

11. The package (100) according to any of claims 1 to 10, wherein the component carrier (102) is connected with the electronic component (108) with continuous physical contact over an entire main surface of the electronic component (108).

12. The package (100) according to any of claims 1 to 11,
wherein the component carrier (102) has a plurality of exposed carrier contacts (104);
wherein the electronic component (108) has a plurality of exposed component pads (110);
wherein the component carrier (102) is connected with the electronic component (108) so that there is a connection, for example with direct physical contact, between each of the carrier contacts (104) and each respective one of the component pads (110).

13. A component carrier (102), which comprises:
a stack (130) comprising at least one electrically conductive layer structure (142) having at least one exposed carrier contact (104) and at least one electrically insulating layer structure (144) having an exposed carrier dielectric (106); and
wherein the carrier dielectric (106) comprises a stress release structure (150) at its exterior surface for direct connection with a component dielectric (112) of an electronic component (108).

14. A method of manufacturing a package (100), wherein the method comprises
providing a component carrier (102) having at least one exposed carrier contact (104) and having an exposed carrier dielectric (106);
providing an electronic component (108) having an integrated circuit (136), having at least one exposed component pad (110) and having an exposed component dielectric (112); connecting the component carrier (102) with the electronic component (108) so that there is a connection between the at least one carrier contact (104) and the at least one component pad (110) and so that there is a direct physical contact between the carrier dielectric (106) and the component dielectric (112); and
providing at least one of the carrier dielectric (106) and the component dielectric (112) with a stress release structure (150, 152) at its surface facing the respectively other one of the carrier dielectric (106) and the component dielectric (112).

15. The method according to claim 14, wherein the method comprises
forming the at least one exposed carrier contact (104) based on an electrically conductive protrusion (170), in particular of a metal pillar, of at least one electrically conductive layer structure (142) of a stack (130) of the component carrier (102); and
forming the protrusion (170) by removing, in particular by etching, material of at least one electrically insulating layer structure (144) of the stack (130) around the at least one electrically conductive layer structure (142).
